Europäisches Patentamt

European Patent Office

Office européen des brevets

(11) Publication number: **0 357 411**
**A2**

## EUROPEAN PATENT APPLICATION

(21) Application number: 89308799.9

(22) Date of filing: 31.08.89

(51) Int. Cl.5: **H 02 M 3/155**

(30) Priority: 31.08.88 US 239295

(43) Date of publication of application:
07.03.90 Bulletin 90/10

(84) Designated Contracting States:
AT BE CH DE ES FR GB GR IT LI LU NL SE

(71) Applicant: ZYTEC CORPORATION
7575 Market Place Drive
Eden Prairie Minnesota 55344 (US)

(72) Inventor: Knights, Michael A.
112014 Faber Lane
Chaska Minnesota 55318 (US)

Beecroft, John W.
1510 West 33rd Street
Minneapolis Minnesota 55408 (US)

Bishop, Walter W.
8321 Emerson Avenue South
Minneapolis Minnesota 55420 (US)

(74) Representative: Muir, Ian R. et al
HASELTINE LAKE & CO. Hazlitt House 28 Southampton
Buildings Chancery Lane
London WC2A 1AT (GB)

(54) Controlled-inductance regulator for switching power supplies.

(57) A post secondary magnetic amplifier circuit for operation
at frequencies at or above 100 kHz with minimal losses is
described. A magnetic amplifier is used to control the
post-secondary current to an LC filter in which the magnetic
amplifier is constructed using an non-nickel core material such
as ferrite having a very narrow B-H operating curve (flat loop) in
which the remanence (residual magnetism) is below 1000
gauss. The magnetic amplifier then operates as a controlled
inductance so that saturation is approached slowly.

FIG. 5

EP 0 357 411 A2

**Description**

## CONTROLLED-INDUCTANCE REGULATOR FOR SWITCHING POWER SUPPLIES

The present invention relates to switching power supplies and in particular to regulation circuits using a saturable inductive element having very low permeability after saturation and very low remanence to operate as a controlled-inductance switch.

Using an inductor as a controlled switch is commonly referred to as a magnetic amplifier. Magnetic amplifiers, or mag amps, have a long history in various applications dating back to the early 1900's. This versatile electronic element continues to be used in many modern switching power supplies. In its simplest form, a mag amp is a coil of wire wound on a core having relatively square or rectangular B-H (flux density-magnetizing force) characteristics. The coil then has two operating states. In the first, when the core is unsaturated, the coil acts as a high inductance blocking current flow and supports a large voltage. Once the core saturates, the impedance of the coil drops to near zero, allowing current to flow with a minimum voltage drop. The mag amp thus operates as a switch controlling current flow through the coil with low losses, capable of operating at a high switching speed.

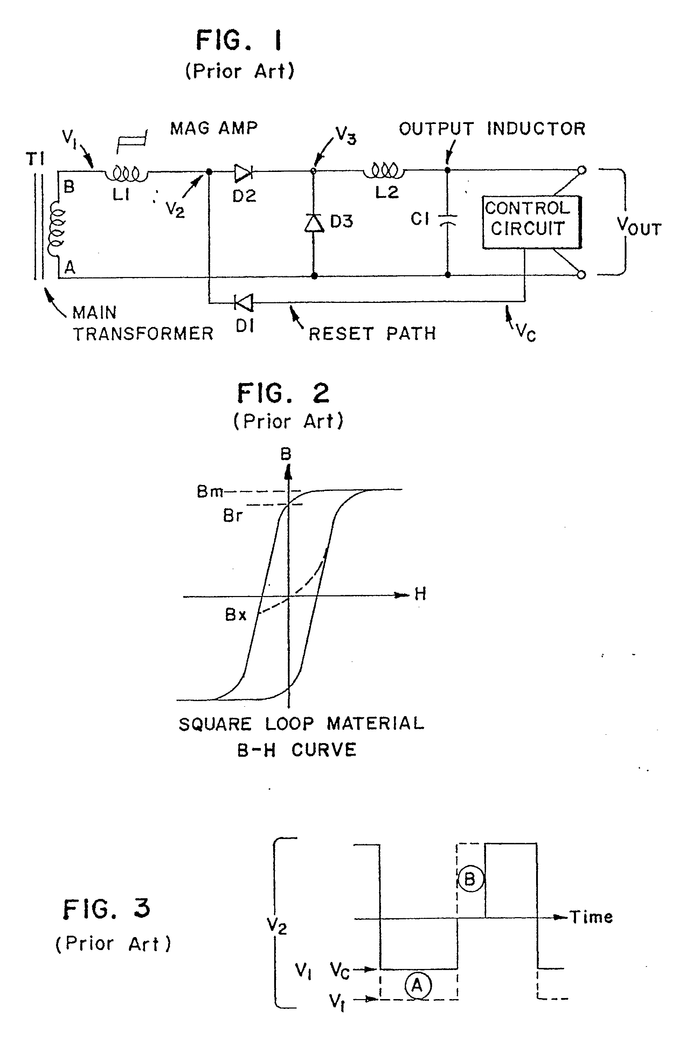

An example of a simple prior art mag amp is shown in Fig. 1. This mag amp is constructed as a portion of a post-regulator circuit in which only the secondary of transformer T1 is shown. The primary of transformer T1 is driven with a square wave from a standard switching power supply with a switching speed of typically 20-70 kHZ. The core material of mag amp L1 uses materials with a square magnetic hysteresis loop of the type shown in Fig. 2 such that the remanent flux density is a high percentage of the saturation flux density. This ensures that the minimum delay between applying a voltage across the mag amp and when the mag amp goes into saturation is as small as possible when no reset is applied. The magnetic amplifier of Fig. 1 acts as a pulse width modulator (PWM) going from high to low impedance when mag amp L1 saturates. The time the mag amp L1 takes to saturate is controlled by allowing current to flow through diode D1 when the transformer T1 reverses polarity during a switching cycle to reset the magnetism of mag amp L1.

The post-regulator circuit shown in Fig. 1 is a buck regulator which requires an output LC filter to convert the pulse width modulated output to DC. The mag amp does not require a DC input, however, since it operates directly off the secondary winding of the power transformer receiving a rectangular or pulse DC waveform. In operation, the mag amp delays the leading edge (see area B of Fig. 3) of the power pulse from power transformer T1 until the remainder of the pulse width is narrowed to maintain the correct output voltage level desired on the output of the post-regulator circuit. Thus, the post-regulator lowers the output voltage and maintains it at a steady voltage independent of the load current.

A control circuit, commonly available in the prior art, can be used to provide the reset voltage necessary to reset mag amp L1 at the appropriate time depending upon the desired output voltage. For example, control circuit part No. UC1838 available from Unitrode Corporation is commonly used. As shown in Fig. 3, the same volt-microseconds induced in the core material in area A during reset is equal to the volt-microseconds in area B which is required to overcome the induced magentism before the mag amp will switch on.

The B-H operating curve of the squared loop material used for magnetic amplifier L1 is shown in prior art Fig. 2. The time to saturation of the core depends upon the core material, area of the core, applied voltage, and number of turns around the loop in mag amp L1. The time to saturation is then determined by the formula

$$T = \frac{N(B_m - B_x) A}{V}$$

where
N = number of turns on the core,
A = area of the core,
V = applied voltage, and
$B_m$ and $B_x$ = operating points determined by the core material.
By varying the characteristics of the mag amp such as the number of turns and the area of the core, one can design a mag amp to be suitable for the desired output voltage of the post-regulator. The control circuit can then adjust the pulse width during which the mag amp is saturated to keep the output voltage constant under varying load conditions. Using square loop material ensures a simple device with one winding which carries both power current and reset control current independently at appropriate times.

All square loop materials exhibit the characteristic where $B_r$ (the remanent flux density) is typically 90% of Bm (the maximum saturation flux density). The square-loop characteristics for a ferrite core material shown in Fig. 2 are $B_m$ approximately equal to 4000 gauss and $B_r$ approximately equal to 3600 gauss. The square-loop characteristics for a ferrite (nickel-based) core material shown in Fig. 2 are $B_m$ approximately equal to 7000 gauss and $B_r$ approximately equal to 6300 gauss.

To obtain increased efficiency and small size of modern switching power supplies, the need to go to higher and higher switching frequencies is apparent. However, because the most suitable square loop material with reasonable magnetic losses at frequencies between 20-100 kHz contains 80% nickel, the cost is becoming increasingly prohibitive to use mag amps as post-regulators. A typical core suitable for a 12V, 10-amp output at 70 kHz costs approximately $2.30 plus a 35¢ nickel surcharge which varies according to the spot market prices. In addition, by pushing the operating frequencies of switching power supplies above 100 kHz, nickel-based cores become increasingly lossy, making the efficiency of the higher-frequency switching power supplies less acceptable. The square-loop magnetic amplifiers of the prior art also switch in such a short period of time that higher frequency harmonics and noise are created which can cause EMI and RF interference exceeding FCC limits.

Ferrite square loop material is known in the prior art and is less expensive (typically $0.40 per core) compared to the nickel-based cores described above. These cores are very lossy at high frequency, the losses being proportional to the area within the square loop shown in Fig. 2. Ferrite square loop characteristics also tend to vary with operating temperature and tend to crack under high temperature operating conditions (related to the high losses and internal heating).

Thus, there is a need in the prior art for a magnetic amplifier post-regulator circuit which uses lower cost core material and operates at frequencies in excess of 100 kHz with minimal losses. In addition, there is a need in the prior art for switching regulators that operate at frequencies in excess of 100 kHz and generate much less EMI and RF interference. In addition, much simpler current regulation in magnetic amplifier post-regulator circuits is a desirable feature lacking in the prior art.

The present invention solves the aforementioned problems in the prior art and other problems that will be recognized by those skilled in the art upon reading this specification. and understanding the present invention. The present invention comprises a regulator circuit employing a magnetic amplifier constructed using non-nickel core material, such as ferrite, having a very narrow B-H operating curve (flat-loop) in which the remenance (residual magnetism $B_r$) is below 1000 gauss. The present invention operates as a controlled inductance so that saturation is approached slowly and allows operations at or above 100 kHz with minimal losses and minimal EMI or RF noise. In addition, the present invention accomplishes current limiting without external current limiting circuitry since the present invention only allows the proportional amount of current out that the control winding current is placed in.

The present invention is designed to be connected to the secondary of the power output transformer of a switching power supply. The present invention operates as a post-regulator with a ferrite-like core material having a narrow B-H characteristic curve. The mag amp is placed in series with the power output transformer and rectifying diodes. The output of the mag amp through a rectifying diode is then placed into an LC filter circuit to provide a smooth stabilized voltage output regardless of the load current. A control circuit is provided as a secondary winding on the magnetic amplifier which provides reset current on the mag amp.

## Brief Description of the Drawings

In the drawings, where like numerals refer to like components throughout the several views,

FIG. 1 shows a prior art magnetic amplifier post-regulator circuit.

FIG. 2 shows a prior art square loop B-H curve for a nickel-based core used in the prior art magnetic amplifier circuit of Fig. 1.

FIG. 3 shows the voltage waveforms across the magnetic amplifier within the prior art circuit of Fig. 1.

FIG. 4 shows the B-H curve for a flat-loop core material used in the magnetic amplifier circuits of the present invention.

FIG. 5 shows a magnetic amplifier post-regulator circuit using the core material of Fig. 4 and using a control winding to control the reset point of the magnetic amplifier.

FIG. 6 shows the voltage and current waveforms at various points along the circuit of Fig. 5.

FIG. 7 shows an alternate embodiment of the present invention using dual cores for the magnetic amplifier.

FIG. 8 is a graph of the control current range for a nominal 50-watt power supply employing the post-regulator circuit of Fig. 7.

FIG. 9 is a schematic diagram of an alternate embodiment of the present invention using one large toroid and one small toroid for greater reset range control.

FIG. 10 is a graph of the control current range for a nominal 50-watt power supply employing the post-regulator circuit of Fig. 8.

FIGS. 11a and 11b shows the voltage and current waveforms for the circuit of Fig. 8.

FIG. 12 shows a three-leg core material implementation of the present connection using a ferrite core.

FIG. 13 shows an alternate form of the three-leg embodiment of the present invention of Fig. 12.

FIG. 14 is a detailed electrical schematic diagram showing the use of the present invention in a post-secondary regulator circuit.

In the following detailed description of the preferred embodiments, reference is made to the accompanying drawings which form a part hereof, and in which is shown by way of illustration specific embodiments in which the present invention may be practiced. These preferred embodiments are described in sufficient detail to enable those skilled in the art to practice the invention, and it is to be understood that other embodiments may be utilized and that structural or electrical changes may be made without departing from the spirit and scope of the present invention. The following detailed description is, therefore, not to be taken in a limiting sense, and the scope of the present invention is defined by the appended claims.

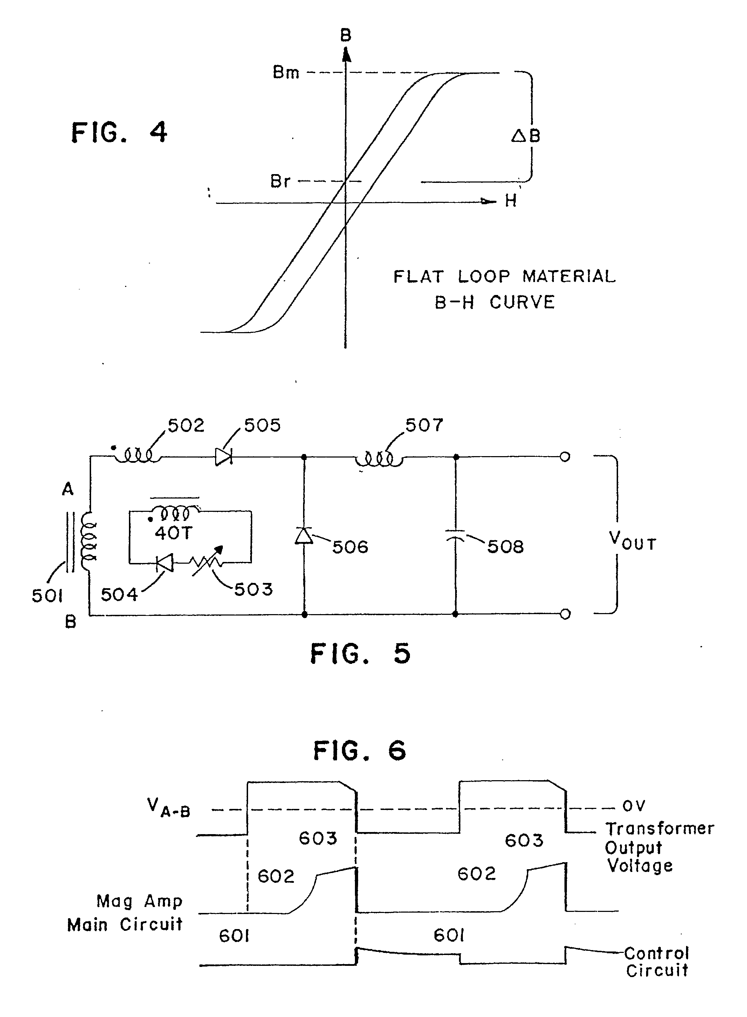

Fig. 4 shows a typical flat-loop B-H curve of a core material such as ferrite used in the magnetic amplifier of the preferred embodiments of the present invention. For purposes of high-frequency operation with low losses, the BH loop should indicate very low permeability after saturation and in a single-ended version of the preferred embodiment of the present invention, the remanence should be as low as possible (below 1000 gauss) to ensure the maximum delta B or switching time from $B_r$ to $B_m$. Those skilled in the art will readily recognize that materials other than ferrite may be used for the magnetic amplifier as long as the remanence of the cores is maintained below 1000 gauss. The square loop characteristics for a ferrite core material shown in Fig. 4 are $B_m$ approximately equal to 4000 gauss and $B_r$ approximately equal to 700 gauss. The remanent flux density $B_r$ is typically 17% of the maximum saturation flux density $B_m$.

Fig. 5 shows a magnetic amplifier using the ferrite core material described by the B-H characteristics of Fig. 4. In this first embodiment of the present invention, a secondary or control winding is added to the ferrite core to help the core saturate and to prevent full automatic reset to remanence in order to vary the pulse width of the current allowed through the mag amp. The circuit of Fig. 5 is connected to a 20-volt, 6-amp output transformer winding 501 of a 400-watt switching power supply (not shown) available from the assignee of the present invention. The mag amp is constructed using a 35mm "E" core with both the main winding and the control winding on the center leg. The material was constructed of a nominal ferrite power material, part No. 3E2E available from FerroxCube, a branch of North American Phillips costing approximate $0.40 a piece in quantity.

To achieve full current blocking (never saturating), the mag amp must hold off the full volt seconds of the secondary of the transformer winding. In the switching power supply described above, a 20-volt peak square wave is produced by transformer 501. The voltage that the main coil of mag amp 502 must hold off is a 20-volt peak for 6 microseconds. Using a core material having an area of approximately 80 square millimeters, the flux excursion allowed between remanence and saturation is approximately 300 millitesla. In order to stay out of saturation, the present invention described in Fig. 5 allowed 250 milliteslas. The number of turns N turns required on the main winding were equal to

$$N = V \cdot \frac{T}{(B_m - B_r)A} = 5.$$

where
V = applied voltage
T = time to saturation in microseconds
($B_m$-$B_r$) = the flux excursion between saturation and reset in Teslas
and
A = area of the core in square millimeters
The control winding was constructed of 40 turns of 23-gauge wire such that the peak voltage due to the turns ratio was approximately 160 volts. A 400-volt 8-amp epitaxial rectifier 504 is placed in series with a 1-kilohm 50-watt potentiometer to control the reset current through the control winding of mag amp 502. The dots on the mag amp winding shown in Fig. 5 show that the current in the control winding flows in the same sense as the main power current when rectifier 505 is forward biased. When the A end of the transformer winding 501 is positive, magnetizing current flows in the main mag amp winding and no current flows in the control winding. If the mag amp saturates, power current flows in the main winding after a delay. When the A end of the transformer 501 goes negative, control current flows in the control winding in such a direction that the core is prevented from fully resetting. This shortens the time it takes to saturate when A goes positive again, and the delay can be varied by varying the control current with the potentiometer 503.

The voltage and current waveforms for the circuit of Fig. 5 are shown in Fig. 6. The approximately 20-volt peak square wave of transformer 501 is shown in the upper portion of Fig. 6 as the transformer output voltage. The current through the mag amp main winding is shown on the second line of Fig. 6 along with the control current through the control winding of mag amp 502 on the third line of Fig. 6. Referring to the second line of Fig. 6, at 601 the mag amp 502 is in a high impedance state and therefore magnetizing current only flows as the core is being magnetized up the steep part of the B-H curve. As the magnetization increases further, saturation is approached as the effective permeability decreases. This causes the inductance to lower and the current can change at an increasing rate as shown at 602. When the core saturates, the current is no longer limited by the mag amp and the slope of the current is then controlled by the inductor 507 as the current in diode 505 climbs above the current in 506. If no control current flows through the mag amp through the control winding, the mag amp never saturates. By its nature, the circuit of Fig. 5 allows a limited control range and the losses in the potentiometer, up to 100 milliamps at 160 volts for half the total period, are significant but in some applications acceptable for using flat-loop ferrite core materials at high frequencies. The high voltages induced in the control winding of the mag amp of 502 are also a problem which can be addressed by the second preferred embodiment described below.

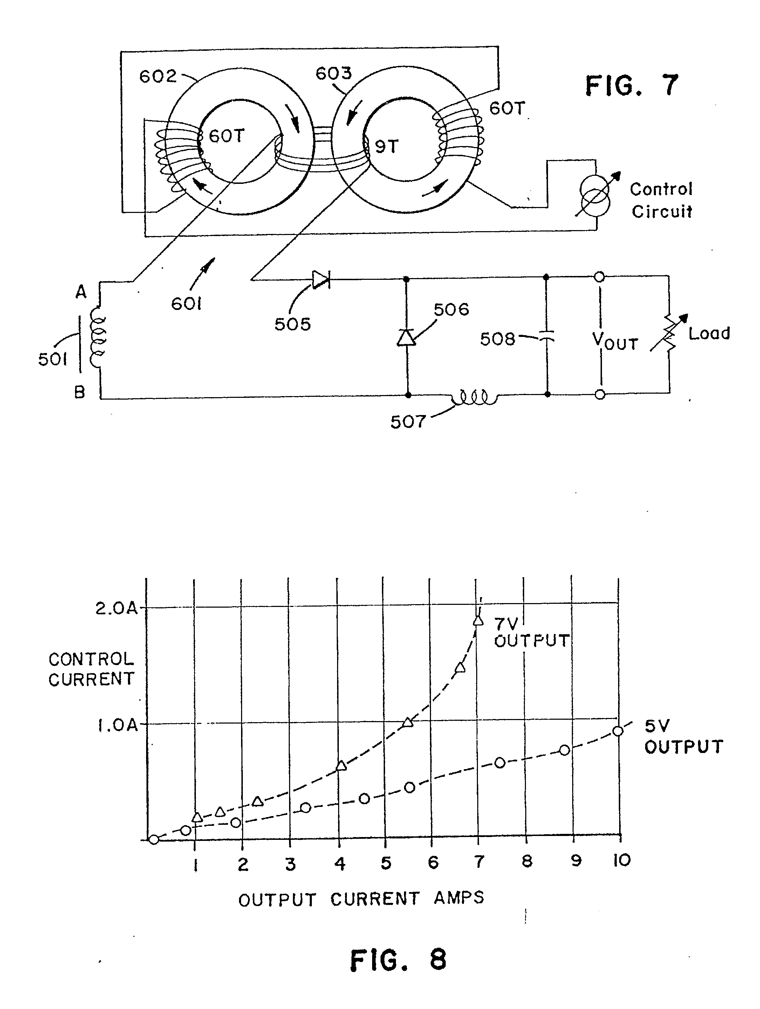

The second preferred embodiment of the present invention shown in Fig. 7 operates to eliminate the problem of high induced voltage in the control winding due to the turns ratio. The two cores shown in Fig. 7 are ferrite core part No. 42908-TC-J available from Magnetics, Inc., a division of Spang & Co. of Butler, Pennsylvania. The control windings are wound such that the voltage induced from one core is equal and opposite to the voltage induced by the other. An external control power supply is used to drive current around the control windings of the mag amp and the voltage required was that necessary to overcome the resistance of the wire of the control windings. As shown in Fig. 7, ferrite core 602 receives nine turns of the main winding in common with ferrite core 603. Control windings of cores 602 and 603 are constructed of sixty turns on each core placed in series with the control circuit. The control circuit produces a control voltage through the windings that may be proportional to the varying load conditions on the output of the circuit of Fig. 7. The main power winding turns were chosen so that with no control current flowing through the control windings, the cores do not saturate.

Referring to Fig. 8, the current amplification of the circuit of Fig. 7 is graphically shown. For a 5-volt post-regulator output, current amplification of better than 10:1 is available.

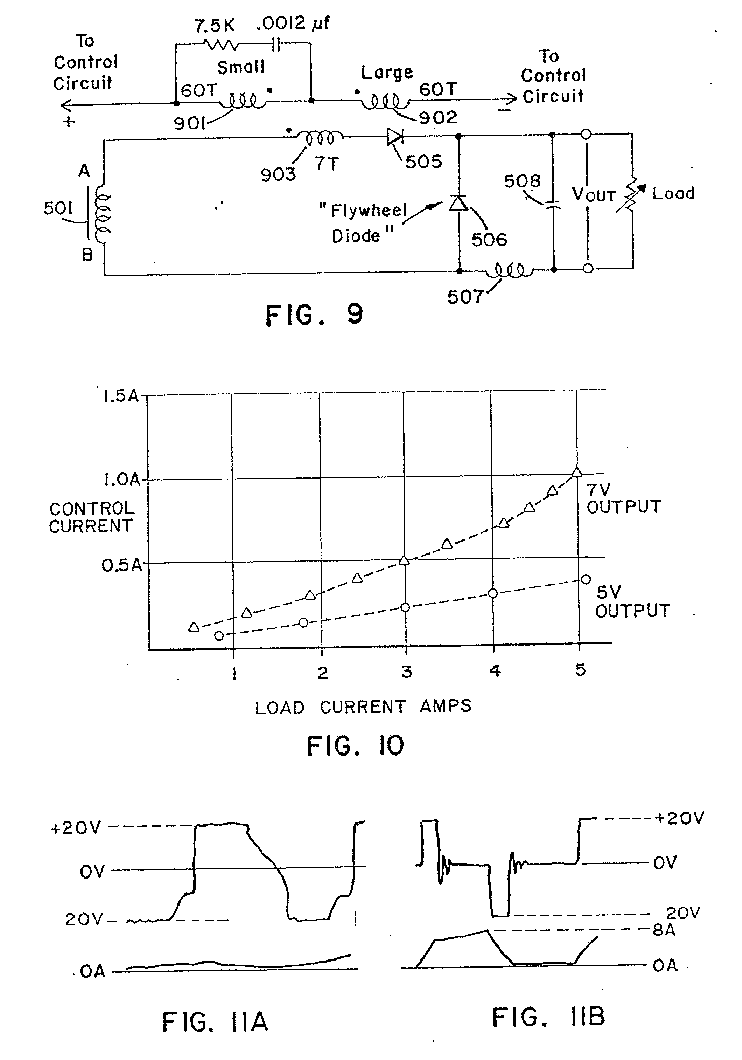

In order to increase the range of current amplification, the third preferred embodiment of the present invention is shown in Fig. 9. A two-toroid mag amp was constructed with one core 901 being smaller than the other core 902. The direction of the windings is shown with dots in Fig. 9, and the physical construction is similar to that of Fig. 7 except for the area of the toroids. Seven turns of the main winding are wound in common between the two toroids, and the control win dings on separate toroids are placed in series with a control circuit to produce the control winding voltage. A snubber circuit is included on the smaller toroid constructed using an RC damping circuit comprised of a 7.5-kilohm resistor in series with a 0.0012 microfarad capacitor placed in parallel with the control winding on the smaller toroid. In using toroids of inequal area, the result is similar to that used with equal area cores with approximately ten percent greater control range. The results are shown in Fig. 10 with a current amplification for a 5-volt output of approximately 13:1.

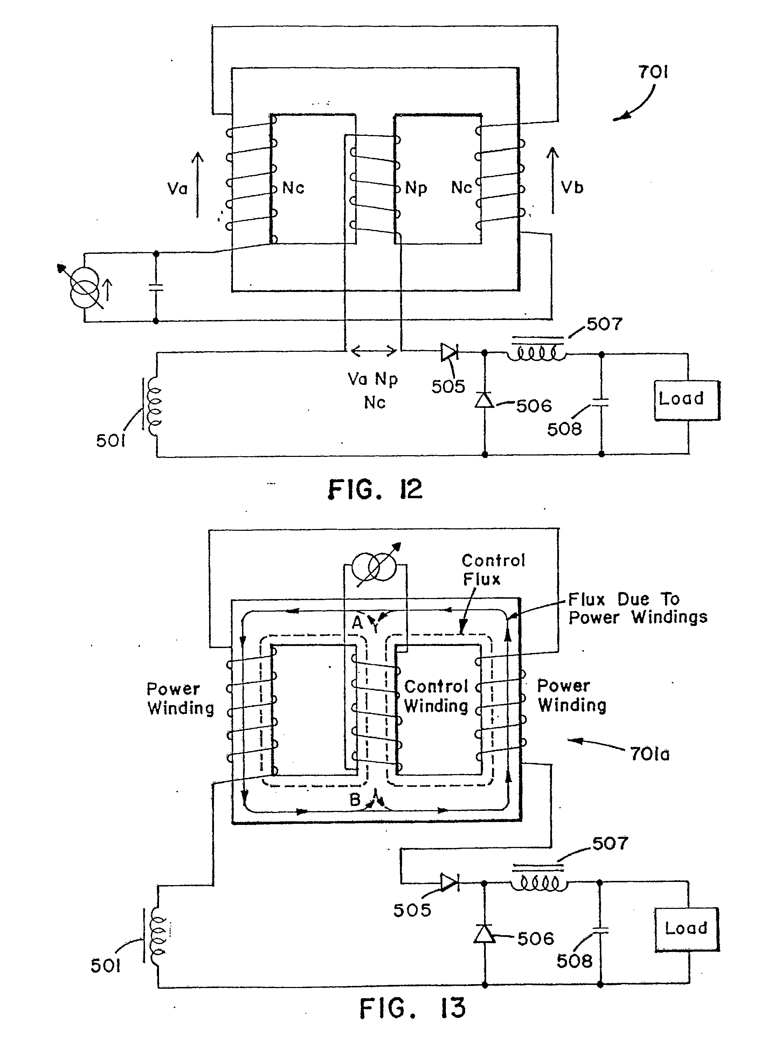

Voltage waveforms taken across the main control winding of the third preferred embodiment of the present invention shown in Fig. 9 are shown in Figs. 11a and 11b. With zero control current, the core will not saturate at the selected frequency of approximately 100 kHz, as shown in Fig. 11a where magnetizing current only is flowing. Zero control current thus effectively blocks all voltage output on the post-regulator circuit since all of the applied voltage from the transformer is dropped across the mag amp. Placing a voltage across the control winding produces an output voltage on the post-regulator circuit proportional to the amount of current induced in the control windings of the toroids. As shown in Fig. 11b, pulse width modulation is taking place at the operating frequency of the switching power supply. The mag amp now supports the applied voltage for approximately a quarter of the total time, and goes quickly into saturation. When the transformer voltage reverses, the voltage across the mag amp reverses and the current falls back to zero at the same slope but reversed sign at which it rose. At saturation the dI/dt is limited by the choke 507. The graphs of Fig. 11a and 11b demonstrate the full control range from blocking (magnetizing current flows only) to maximum output. Beyond a control current of 0.75 amps, the control becomes non-linear and doubling the control current only gives ten percent more output current (at the same voltage).

As shown in Fig. 7, and implied by the windings of Fig. 9, the current in the control winding gives rise to a magneto motive force (MMF) which is shown by the arrows on the toroids of Fig. 7. The direction of the MMF caused by control winding in one core opposes the MMF caused by the main winding, while in the other core the direction of the MMF caused by the control winding adds to the MMF caused by the main winding. Thus, the inductance during the current rise and fall times decreases as the current in the control winding increases.

In the increased control range embodiment of the present invention shown in Fig. 9, the smaller core 901 of Fig. 9 (in which the two MMFs add) is moved quickly toward saturation and thus ceases to support the voltage across its control winding. However, since the control winding on core 901 is connected to the other control winding on core 902, the voltage across it is fixed by the former. As the main winding current increases, its flux balances the flux due to the control current in the core with the opposing MMFs, at which point the inductance goes toward zero. Because the voltage across the control winding of 901 decreases, the opposing flux in core 902 reduces, allowing the balancing from main winding to occur earlier. Thus, the current ramps up faster to a level when it is saturated. Thus, core 902 acts as a current transformer as the core 901 goes into saturation.

The alternate embodiments of Figs. 5, 7 and 9 demonstrate that a high-frequency, low-loss mag amp is feasible using flat-loop material. This design overcomes the potential frequency limits of the square-loop materials because the aforementioned embodiments incorporate soft ferrite materials and the like which have superior high-frequency performance. As shown in Fig. 7, the concept of using opposing control windings to cancel the induced voltages in the control circuit simplifies the design since the control circuit does not need to be high-voltage isolated or protected. As shown in Fig. 12, the concepts of Figs. 7 and 9 are incorporated by substituting an E core 701 for the individual two toroids in which the power winding is wound around the center leg. In this embodiment, similar to the embodiments of Figs. 7 and 9, the mag amp changes state when one of the outer legs saturates. In the unsaturated state, any voltage appearing across the transformer 501 will induce a voltage (determined by the turns ratio $N_c/N_p$) across the control windings ($V_a$ and $V_b$). When an outer limb of the magnetic core saturates, the voltage induced across that winding collapses, and because of the conection of the two control windings, the other control winding has the same loss of voltage. A corresponding drop in voltage across the power winding $N_p$ removes the "blocking condition" and current can flow through $N_p$ up to a maximum value determined by the control winding current and the turns ratio $N_c/N_p$. In this condition, the device has changed state from a voltage transformer to a current transformer, the current of which is determined by the control current. This state will remain until the rest of the device reaches saturation, at which time all controlling influence will be lost.

In this fashion, by altering the control current with a closed loop feedback system, automatic output voltage control can be achieved for a very wide range of load conditions. The system has inherent current limiting properties which further simplifies the control circuit over the square-loop type mag amp circuits.

An alternate embodiment to that shown in Fig. 12 is shown in Fig. 13, where the power windings are on the outer legs and the control winding on the center pole. No AC component is induced in the control winding from the power windings since any flux from one power winding which tries to enter the center pole is opposed by the flux from the other power winding (see positions A and B on Fig. 13). The flux from the control winding, however, adds to the power flux in one leg, and opposes the power flux in the other leg in the same way as the previous embodiment, and the manner of control is similar. The main advantage with the method of Fig. 13 is that the control winding sees no AC flux, whereas in the Fig. 12 method, the AC flux which one half of the control winding sees includes voltages which are balanced by the voltages in the other half by the method of connection. However, at the junction of the two halves of the control winding high voltages (200V-600V) are observed. so suitable insulation has to be provided.

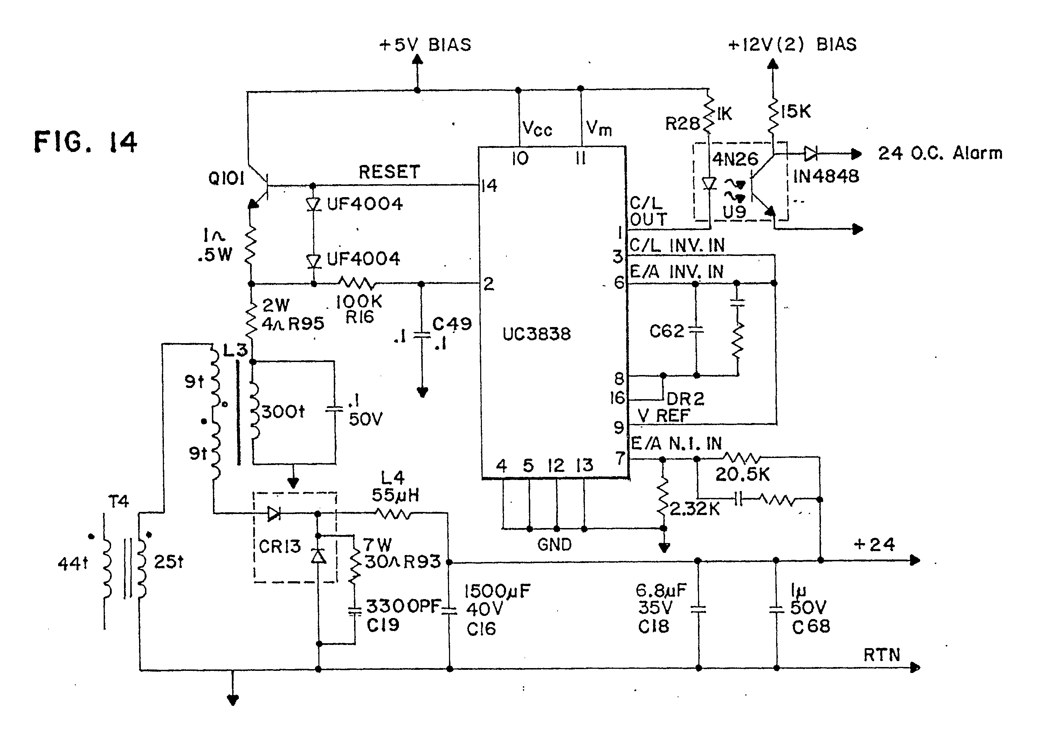

Fig. 14 shows a post regulator circuit which employs a preferred embodiment of the present invention. Inductor L3 corresponds to the flat-loop ferrite double E core configuration shown in Fig. 13. Two opposing nine-turn windings for the power windings are wound on the outer legs of the core with a 300-turn control winding wound on the center leg of the core controlled by a magnetic amplifier controller chip and associated circuitry. The magnetic amplifier L3 is connected according to the teachings of the present invention to control a +24 volt DC post regulator circuit employing an LC filter comprised of inductor L4 and capictors C16, C18, C68. The post regulator circuit derives its pulse power from the secondary of transformer T4, the primary of which (not shown) is attached to the output of a switching power supply.

The magnetic amplifier controller integrated circuit UC3838 (available from Unitrode) contains all of the circuitry necessary to generate and amplify a low level analog error signal which is used to produce the reset current to enable a magnetic amplifier to regulate a power supply output. The integrated circuit is connected according to manufacturer specifications to receive a voltage feedback signal on pin 7 and produce the reset signal on pin 14. The reset signal on pin 14 is used to drive the base of transistor Q101 which in turn controls the reset voltage to the control winding of the flat-loop magnetic.amplifier L3. Integrated circuit UC3838 defines the amount of volt-seconds the magnetic amplifier L3 will block before switching to the conducting state. The integrated circuit UC3838 shown in Fig. 14 is manufactured and sold to operate on a square-loop core material for a magnetic amplifier. With the implementation shown in Fig. 14, the integrated circuit can be connected to operate on the flat loop ferrite-type core materials as described in the preferred embodiments of the present invention.

While the present invention has been described in connection with the preferred embodiments thereof, it will be understood that many modifications will be readily apparent to those of ordinary skill in the art, and this application is intended to cover any adaptations or variations thereof. Therefore, it is manifestly intended that this invention be limited only by the claims and the equivalents thereof.

**Claims**

1. A post-regulation circuit, comprising:
a source of pulsed DC current;
a magnetic amplifier connected to said source of DC current and having a core material which exhibits flat loop B-H characteristics with remanence below 1000 gauss;
rectifier means connected to said magnetic amplifier for receiving controlled current from said magnetic amplifier and for rectifying said controlled current to produce rectified current;
filter means connected to said rectifier means for filtering said rectified current received from said rectifier means; and
control means connected to said magnetic amplifier for controlling said controlled current.

2. The circuit according to claim 1 wherein said magnetic amplifier is constructed using flat-loop ferrite core material.

3. The circuit according to claim 1 wherein said magnetic amplifier is constructed using two cores of said core material having a power winding commonly wound around both cores and connected to said source of pulsed DC current and to said rectifier means and having a control winding serially wound around both cores and connected to said control means.

4. The circuit according to claim 1 wherein said magnetic amplifier is constructed using two cores of said core material having a power winding serially wound around both cores and connected to said source of pulsed DC current and to said rectifier means and having a control winding commonly wound around both cores and connected to said control means.

5. The circuit according to claim 3 wherein said cores are of different size.

6. The circuit according to claim 4 wherein said cores are of different size.

7. The circuit according to claim 1 wherein said magnetic amplifier is constructed using a double E core of said core material having a power winding wound around the center leg of said double E core and connected to said source of pulsed DC current and to said rectifier means and having a control winding serially wound around the outer legs of said double E core and connected to said control means.

8. The circuit according to claim 1 wherein said magnetic amplifier is constructed using a double E core of said core material having a power winding serially wound around the outer legs of said double E core and connected to said source of pulsed DC current and to said rectifier means and having a control winding wound around the center leg of said double E core and connected to said control means.

# FIG. 1
(Prior Art)

MAG AMP    OUTPUT INDUCTOR

$V_1$  $V_3$

T1

B

L1  $V_2$  D2  D3  L2  C1  CONTROL CIRCUIT  $V_{OUT}$

A

MAIN TRANSFORMER  D1  RESET PATH  $V_C$

# FIG. 2
(Prior Art)

B

Bm

Br

H

Bx

SQUARE LOOP MATERIAL
B-H CURVE

# FIG. 3
(Prior Art)

$V_2$

$V_1$  $V_C$  (A)

(B)  Time

$V_1$

# FIG. 4

B

Bm

Br

$\triangle$B

H

FLAT LOOP MATERIAL
B-H CURVE

A

501

B

502   505

507

40T

504   503

506

508

$V_{OUT}$

# FIG. 5

# FIG. 6

$V_{A-B}$

0V

603   603   Transformer
Output
Voltage

602   602

Mag Amp
Main Circuit

601   601

Control
Circuit

FIG. 7

FIG. 8

FIG. 9

LOAD CURRENT AMPS

FIG. 10

FIG. 11A

FIG. 11B

Va | Nc | Np | Nc | Vb

Va Np
Nc

505 | 507 | 506 | 508

501 | Load

FIG. 12

Control
Flux

Flux Due To
Power Windings

Power
Winding

Control
Winding

Power
Winding

A

B

701a

507

505 | 506 | 508

501 | Load

FIG. 13

FIG. 14

EP 0 357 411 A2